# EUROPÄISCHE PATENTSCHRIFT

(11) **EP 2 723 549 B1**
(45) Veröffentlichungstag und Bekanntmachung des Hinweises auf die Patenterteilung: **16.10.2019**
(21) Anmeldenummer: 12729005.4
(22) Anmeldetag: 21.06.2012
(51) Int. Cl.: B22F 3/105, B29C 64/153, B29C 70/70, H01L 41/053, H01L 41/23, H01L 41/257

(54) **VERFAHREN ZUR HERSTELLUNG EINER WENIGSTENS EINE KOMPONENTE ZUMINDEST TEILWEISE UMSCHLIEßENDEN GEHÄUSESTRUKTUR SOWIE EINE MIT DEN VERFAHREN HERGESTELLTE GEHÄUSESTRUKTUR**
METHODs FOR PRODUCING A HOUSING STRUCTURE AT LEAST PARTIALLY ENCLOSING AT LEAST ONE COMPONENT AND HOUSING STRUCTURE PRODUCED BY SAID METHODs
PROCÉDÉS DE FABRICATION D'UNE STRUCTURE D'ENVELOPPE ENVELOPPANT AU MOINS PARTIELLEMENT AU MOINS UN COMPOSANT AINSI QU'UNE STRUCTURE D'ENVELOPPE FABRIQUÉE SELON LESDITS PROCÉDÉS

(30) Priorität: 21.06.2011 DE 102011105044
(43) Veröffentlichungstag der Anmeldung: 30.04.2014
(73) Patentinhaber: Fraunhofer Gesellschaft zur Förderung der angewandten Forschung E.V., 80686 München (DE); Technische Universität Darmstadt, 64289 Darmstadt (DE)
(72) Erfinder: RAUSCHENBACH, Matthias, 64289 Darmstadt (DE); FLASCHENTRÄGER, David, 64293 Darmstadt (DE); MELZ, Tobias, 64285 Darmstadt (DE); ABELE, Eberhard, 77815 Bühl (DE); FISCHER, Jakob, 65527 Engenhahn (DE); STOFFREGEN, Hanns, 60327 Frankfurt (DE)
(74) Vertreter: Rösler, Uwe
(86) Internationale Anmeldenummer: PCT/EP2012/002624
(87) Internationale Veröffentlichungsnummer: WO 2012/175209

(56) Entgegenhaltungen:
- US-B1- 6 450 393
- Paul Calvert ET AL: "FREEFORM FABRICATION OF COMPOSITES WITH EMBEDDED SENSORS", SPIE Conference on Sensory Phenomena and Measurement Instrumentation for Smart Structures and Materials, 1. Januar 1999 (1999-01-01), Seiten 128-133, XP55041605, Gefunden im Internet: URL:http://spiedigitallibrary.org/data/Con ferences/SPIEP/51362/128_1.pdf [gefunden am 2012-10-19]
- Rahul Rai ET AL: "Extracting product performance by embedding sensors in SFF prototypes", Proceeding of the Solid Freeform Fabrication Symposium, August 3-5, Austin, TX., 1. Januar 2004 (2004-01-01), Seiten 366-376, XP55041225, Gefunden im Internet: URL:http://utwired.engr.utexas.edu/lff/sym posium/proceedingsArchive/pubs/Manuscripts /2004/2004-36-Rai.pdf [gefunden am 2012-10-16]
- Li Xiaochun: "EMBEDDED SENSORS IN LAYERED MANUFACTURING", , 1. Januar 2001 (2001-01-01), XP55040671, Gefunden im Internet: URL:http://npl-web.stanford.edu/user/files /papers/thesis_xcli.pdf [gefunden am 2012-10-10]
- STEWART SHERRIT ET AL: "Monolithic rapid prototype flexured ultrasonic horns", ULTRASONICS SYMPOSIUM (IUS), 2010 IEEE, IEEE, 11. Oktober 2010 (2010-10-11), Seiten 886-889, XP031952579, DOI: 10.1109/ULTSYM.2010.5935440 ISBN: 978-1-4577-0382-9

## Beschreibung

### Technisches Gebiet

Die Erfindung bezieht sich auf ein Verfahren zur Herstellung einer wenigstens eine Komponente zumindest teilweise umschließenden Gehäusestruktur, wobei die Gehäusestruktur im Rahmen eines durch wiederholtes schichtweises Abscheiden und/oder Verfestigen von Material geprägten Bauprozesses hergestellt wird, der vor Fertigstellung der Gehäusestruktur wenigstens einmalig unterbrochen wird, und während der einen Unterbrechung an oder in die teilgefertigte Gehäusestruktur die wenigstens eine Komponente gefügt wird, die nicht mit dem Bauprozess hergestellt ist. Im Anschluss an die eine Unterbrechung wird der Bauprozess fortgesetzt, bis das Gehäuse, das die wenigstens eine Komponente zumindest teilweise umfasst, fertig gestellt ist. Ferner wird eine mit dem Verfahren hergestellte Gehäusestruktur beschrieben.

### Stand der Technik

In einer Vielzahl technischer Anwendungen gilt es, technische Komponenten vor Umwelteinflüssen oder in umgekehrter Betrachtungsweise die Umwelt vor möglichen Gefahren, die von Komponenten ausgehen, zu schützen. Hierzu gilt es die jeweilige Komponente in eine Umhausung unterzubringen, deren Form, Größe und Beschaffenheit hinsichtlich physikalischer und chemischer Eigenschaften von der Art der jeweils innerhalb der Umhausung unterzubringenden Komponente abhängen.

Typischerweise bestehen derartige Gehäuse bzw. allgemein derartige Gehäusestrukturen aus mehreren Gehäuseteilen, beispielsweise Gehäuseboden und Gehäusedeckel, die es mit Hilfe geeigneter Verbindungsmittel, beispielsweise in Form von Schrauben, Nieten, Klebungen oder ähnliche Mittel, miteinander zu fügen gilt. Nehmen die Gehäuseformen aufgrund der darin unterzubringenden Komponenten an Komplexität zu, so erhöht sich nicht nur der Kostenfaktor zur Herstellung derartiger Strukturkomponenten, vielmehr erhöht sich auch die Unzuverlässigkeit hinsichtlich der Gehäuseschutzfunktion, da bei komplexen Gehäusestrukturen und -formen Gehäusefügeverbindungen in Form von Verschraubungen oder Klebungen oder Ähnlichem einer höheren Beanspruchung unterliegen, wodurch derartige Verbindungen geschwächt bzw. gelöst werden können. Ferner gestaltet sich der Aufwand zur Herstellung individualisierter und komplex gestalteter Gehäuseformen als durchaus beträchtlich, insbesondere im Hinblick auf die Herstellungszeit sowie auch Herstellungskosten.

Je nach Materialwahl, die zur Ausbildung der jeweiligen Gehäusestruktur getroffen worden ist, sind entsprechende Bearbeitungs- und Formgebungstechniken zu verwenden, um die einzelnen Gehäusestrukturen zu fertigen und entsprechend zu montieren. In der Regel erfolgt die Herstellung der einzelnen Gehäuseteile in separaten Fertigungsschritten, getrennt zur Herstellung und Bevorratung der jeweils einzuhausenden Komponenten.

Neben konventionellen Herstellungsverfahren, mit denen Gehäusestrukturen aus Einzelteilen zusammengesetzt werden, erlauben gießtechnische Verfahren eine einstückige Herstellung einer Gehäusestruktur, bei denen zudem während des Gießprozesses die vom Gehäuse zu umschließende Komponente in die Gehäusestruktur eingegossen bzw. umgossen wird. Da derartige gießtechnische Verfahren zumeist hohe Prozesstemperaturen erfordern, sind für derartige Umhausungsprozesse lediglich temperaturbeständige Komponenten geeignet.

Die Druckschrift DE 10 2009 043 597 A1 offenbart ein Verfahren zum Herstellen eines markierten Gegenstands mithilfe eines additiven Herstellungsverfahrens. In einer Ausführungsform des Verfahrens werden Hohlräume in dem zu markierenden Gegenstand erzeugt, die während einer Fertigungsunterbrechung von losem, unverfestigtem Material befreit und anschließend mit magnetischem Material verfüllt werden. Anschließend wird der additive Herstellungsprozess fortgeführt.

Die Druckschrift US 2009/0173443 A1 beschreibt ein Verfahren zur Herstellung eines dreidimensionalen Objekts mittels eines generativen Fertigungsverfahrens, in dem ein Identifikations-Mittel (ID-Tag) vollständig oder teilweise eingebettet wird. Das ID-Tag kann dabei sowohl horizontal in einer oder mehreren Lagen oder auch vertikal oder "nahezu vertikal" in das 3D-Objekt eingebettet werden.

Die Druckschrift DE 198 57 550 A1 offenbart ein Verfahren zur Verkapselung von metallischen Mikrobauteilen, die auf einer Chipfläche mit integrierten Auswerteschaltkreisen angeordnet werden. Zur Flächeneinsparung wird eine Schutzkappe nicht außerhalb der integrierten Schaltungen, sondern direkt über diesen angeordnet. Hierbei werden die entsprechenden Bereiche der integrierten Schaltungen mit einer Schutzschicht versehen, auf die das Verbindungsmedium, z.B. Glaslot oder Epoxy-Kleber, aufgebracht wird, mit dem der Wafer und die Schutzkappe miteinander verbunden werden. Die Schutzkappe und der Wafer umschließen eine Kaverne, in der die Mikrobauteile angeordnet sind.

Der Druckschrift DE 20 2006 010 214 U1 ist ein Behältnis zur Lagerung und zum Transport von Stück- und Schüttgütern zu entnehmen, das im Rahmen eines IN-MOLD-Verfahrens mit einem einen RF-Transponder tragenden Etikett verbunden wird.

Aus einem Artikel von Paul Calvert et al., "Freeform Fabrication of Composites with embedded Sensors", SPIE Vol. 3679, März 1999, geht die Einbettung eines Sensors innerhalb einer Komponente hervor, die mit Hilfe eines generativen Fertigungsverfahrens hergestellt wird. Insbesondere wird erläutert, dass zur sensoriellen Erfassung des Aushärteprozesses eines aus Epoxidharz im Wege eines Freiformprozesses hergestellten Formkörpers ein piezoelektrisches Plättchen zwischen zwei Epoxidharzschichten eingebracht wird. Infolge des Aushärtevorganges, der durch eine Erwärmung unterstützt werden kann, können etwaige auf das piezoelektrische Plättchen einwirkende mechanische Spannungen erfasst werden.

In einem Beitrag von Rahul Rai, Matthew Campbell und Kristin Wood, "Extracting Product Performance by Embedding Sensors in SFF Protozypes", Dep. of Mech. Engineering, University of Texas Austin, ist eine Machbarkeitsstudie offenbart, die die Möglichkeit überprüft, einen generativen Herstellungsprozess zu unterbrechen, um einen Sensor, beispielsweise in Form eines thermischen Sensors oder eines Dehnungsmessstreifens, innerhalb eines durch Freiformen geformten Körpers zu integrieren. Der Vorgang der Sensorimplementierung verbessert werden, indem für die Implementierung des Sensors ein automatisches Handhabungssystem eingesetzt wird.

### Darstellung der Erfindung

Der Erfindung liegt die Aufgabe zugrunde, ein Verfahren zur Herstellung einer wenigstens eine Komponente zumindest teilweise umschließenden Gehäusestruktur derart anzugeben, dass beliebige Gehäuseformen realisierbar sind, ohne dabei hohe Herstellungskosten sowie lange Herstellungszeiten in Kauf nehmen zu müssen.

Ferner sollte es möglich sein, wenigstens eine Komponente vorzugsweise vollumfänglich in eine hochkomplex geformte Gehäusestruktur einzubringen, ohne dabei Gefahr laufen zu müssen, dass die Gehäusestruktur durch belastungsrelevante Schwachstellen, wie sie bei herkömmlichen Umhausungen in Form von Gehäusefügestellen vorhanden sind, geschwächt sein könnte.

Mit Hilfe des Verfahrens gilt es vor allem eine aktorische und/oder sensorische Funktionseinheit zu realisieren, die wenigstens ein Aktor und/oder Sensorelement beinhaltet, das zumindest weitgehend vollständig vor äußeren Einflüssen geschützt gelagert sein.

Die Lösung der der Erfindung zugrunde liegenden Aufgabe ist im Anspruch 1, 8, 10 und 11 angegeben. Gegenstand des Anspruches 13 ist eine lösungsgemäß ausgebildete Gehäusestruktur. Den Erfindungsgedanken in vorteilhafter Weise weiterbildende Merkmale sind Gegenstand der Unteransprüche sowie der weiteren Beschreibung, insbesondere unter Bezugnahme auf die Ausführungsbeispiele zu entnehmen.

Das lösungsgemäße Verfahren zur Herstellung einer wenigstens eine Komponente zumindest teilweise umschließenden Gehäusestruktur, die im Rahmen eines durch wiederholtes schichtweises Abscheiden und/oder Verfestigen von Material geprägten Bauprozesses hergestellt wird, der vor Fertigstellung der Gehäusestruktur wenigstens einmalig unterbrochen wird, und während der einen Unterbrechung an oder in die teilgefertigte Gehäusestruktur die wenigstens eine Komponente gefügt wird, die nicht mit dem Bauprozess hergestellt ist, und im Anschluss an die eine Unterbrechung der Bauprozess fortgesetzt wird, bis das Gehäuse, das die wenigstens eine Komponente zumindest teilweise umfasst, fertig gestellt ist, zeichnet sich dadurch aus, dass als die wenigstens eine an oder in die Gehäusestruktur zu fügende Komponente ein zumindest teilweise aus einem Wandlerwerkstoff bestehendes Aktor- und/oder Sensorelement gewählt wird und dass während und/oder nach dem Bauprozess Teilbereiche der sich ausbildenden oder ausgebildeten Gehäusestruktur lokal erwärmt oder gekühlt werden zur Initiierung einer thermomechanischen Schrumpfung der die wenigstens eine Komponente zumindest teilweise umfassenden Gehäusestruktur derart, dass eine mechanische Vorspannung in Form einer ausschießlich zweiseitig entgegen gerichteten, von Seiten der Gehäusestruktur auf das eingehauste Aktor- und/oder Sensorelement einwirkenden Presskraft wirkt.

Derartige schichtförmige Bauprozesse werden als generative Herstellungsverfahren bezeichnet, mit denen es möglich ist dreidimensionale Gegenstände in einstückig, monolithischer Bauweise auf der Grundlage eines die Form und Größe des Gegenstandes beschreibenden numerischen Datensatzes zu fertigen. Der durch wiederholte, additive schichtförmige Materialabscheidung und/oder durch schichtförmige Materialverfestigung charakterisierte generative Bauprozess, wird wenigstens einmalig unterbrochen, in einem Stadium, in dem eine teilgefertigte Gehäusestruktur vorliegt. Während der Prozessunterbrechung wird an oder in das bereits teilgefertigte Gehäusestück wenigstens das zumindest teilweise aus einem Wandlerwerkstoff bestehende Aktor- und/oder Sensorelement gefügt, das separat zum Bauprozess bevorratet und somit nicht gemeinsam mit dem Bauprozess zur Herstellung der Gehäusestruktur gefertigt wird. Der Fügevorgang kann manuell oder automatisiert, d.h. Roboter-unterstützt, durchgeführt werden. Sobald der Fügevorgang abgeschlossen ist wird der Bauprozess fortgesetzt, bis die Gehäusestruktur, die das wenigstens eine Aktor- und/oder Sensorelement zumindest teilweise umfasst, fertig gestellt ist.

Der Begriff "Gehäusestruktur" soll im Zusammenhang mit dem Erfindungsgedanken nicht nur auf eine Baueinheit beschränkt zu verstehen sein, deren einzige technische Funktion in der Umhausung eines Aktor- und/oder Sensorelements zu sehen ist, vielmehr sollen in diesem Zusammenhang auch technische Strukturkomponenten beliebiger Art in Betracht kommen, die lokal wenigstens ein Aktor- und/oder Sensorelement zumindest teilweise umfassen bzw. kapseln.

In besonders vorteilhafter Weise eignen sich generative Herstellungsverfahren zur Ausbildung von Gehäusestrukturen, die die wenigstens eine Komponente in einstückiger Bauweise vollständig umschließen, so dass das wenigstens eine Aktor- und/oder Sensorelement durch die Gehäusestruktur bspw. vor Umwelteinflüssen geschützt ist. Aufgrund der einstückigen Bauweise werden keine Verbindungs- und Dichtelemente, die den eingangs erläuterten betriebs- oder nutzungsbedingten Belastungs- oder Verschleißerscheinungen unterliegen, benötigt. Auch ist die Ausbildung von komplexen Gehäuseformen mit Hilfe generativer Bauprozesse verhältnismäßig schnell und kostengünstig im Vergleich mit konventionellen Bauweisen realisierbar.

Die Unterbrechung des generativen Bauprozesses für die Herstellung einer Gehäusestruktur kann in vorteilhafter Weise neben der Anbringung bzw. Einbringung wenigstens des Aktor- und/oder Sensorelements in das teilgefertigte Gehäusestück auch für technische Manipulationen an dem Gehäusestück genutzt werden, die nicht im Rahmen des generativen Bauprozesses realisierbar sind. So kann beispielsweise die Oberflächenbeschaffenheit des teilgefertigten Gehäusestückes mit Hilfe mechanischer Oberflächenbearbeitungstechniken, beispielsweise mittels Fräsen, Bohren, Schleifen, Polieren oder Schneiden, um in nicht abschließender Weise die gängigsten derartiger Oberflächenbearbeitungen zu nennen, verändert werden. Beispielsweise lässt sich auf diese Weise die durch das Baumaterial vorgegebene Oberflächenstruktur bzw. -textur des teilgefertigten Gehäuses modifizieren. Auch können während der Prozessunterbrechung thermische Oberflächenbehandlungen vorgenommen werden, beispielsweise mittels konvektiver Wärmeeinwirkung oder mittels Strahlungswärme.

Gilt es, die Oberflächenbeschaffenheit der teilgefertigten Gehäuseform lokalen oder großflächigen Ätzprozessen zu unterwerfen, oder mittels galvanischer Materialabscheidung entsprechend zu beschichten, so können geeignet gewählte chemische Oberflächenbearbeitungstechniken eingesetzt werden. Auch lassen sich physikalische Beschichtungsverfahren an der teilgefertigten Gehäusestrukturform mittels Aufdampfen aus der Gasphase, Aufsputtern, um nur einige zu nennen, anwenden. Lokale Materialabtragungen können je nach Art des Baumaterials auch mit Hilfe elektroabrasiver Prozesse durchgeführt werden.

Nach Beendigung derartiger, das teilgefertigte Gehäusestück modifizierender Bearbeitungsschritte, lässt sich der generative Bauprozess fortsetzen, bis die wenigstens eine Komponente zumindest teilweise, vorzugsweise vollumfänglich vom Gehäuse umfasst ist.

In vorteilhafter Weise lässt sich der generative Bauprozess mehr als einmal unterbrechen, um weitere Möglichkeiten der Manipulation an der zu fertigenden Gehäusestruktur zu schaffen. So kann vor oder nach der wenigstens einen Unterbrechung des Bauprozesses und vor Fertigstellung der Gehäusestruktur wenigstens eine weitere Unterbrechung des Bauprozesses vorgenommen werden, während der an oder in das teilgefertigte Gehäusestück wenigstens eine weitere Komponente gefügt und/oder am teilgefertigten Gehäuse eine weitere Manipulation vorgenommen wird, die im Rahmen des Bauprozesses nicht durchführbar ist, wie vorstehend zu den unterschiedlichen Oberflächenbearbeitungstechniken erläutert. Auf diese Weise lässt sich die Gehäusestruktur an unterschiedlichen Stellen innerhalb der sich ausbildenden Gehäusestruktur neben des wenigsten einen Aktor- und/oder Sensorelement mit mehreren Komponenten bestücken sowie mit geeigneten technischen Funktionselementen bzw. Funktionsflächen ausbilden. Geeignete Beispiele hierfür werden nachstehend unter Bezugnahme auf die Ausführungsbeispiele erläutert.

Um den Bauprozess nach der Unterbrechung sorgfältig weiterführen zu können, bedarf es einer Überprüfung und bedarfsweise einer Systemjustage der für die Bauprozessdurchführung erforderlichen Apparatur zur Gewährleistung einer sich an die bereits teilgefertigte Gehäusestruktur passgenau anschließenden weiteren schichtweisen Materialabscheidung und/oder Materialverfestigung. Die Überprüfung sowie gegebenenfalls Systemjustage kann manuell oder mittels geeigneter Sensorsysteme erfolgen.

Grundsätzlich lässt sich das lösungsgemäße Verfahren zur Herstellung beliebig komplexer und beliebig großer Gehäusestrukturen anwenden. Zwar bestehen technische Realisierungsgrenzen, insbesondere seitens verfügbarer Systeme zur Durchführung generativer Herstellungsverfahren, diese erfahren jedoch eine stete technische Fortentwicklung.

Der Fokus der im Weiteren beschriebenen Gehäusestrukturen und die damit verbundene Gehäusefunktion liegt in der Einkapselung bzw. Einhausung von aktorischen und/oder sensorischen Systemen, die zumindest teilweise Wandlermaterial bzw. Wandlermaterialien der nachstehend genannten Gattung aufweisen: piezoelektrische Kristalle, piezoelektrische Keramiken, piezoelektrische Primäre, elektrostriktive Materialien, wie elektrostriktive Keramiken, elektrorheologische Fluide, elektroaktive Polymere, magnetorheologische Fluide, Formgedächtnislegierungen oder Formgedächtnispolymere.

Aktorische und/oder sensorische Systeme, insbesondere auf Basis der vorstehend genannten Wandlerwerkstoffe bzw. Materialien bedürfen in besonders vorteilhafter Weise einer vor Umwelteinflüssen schützenden Einhausung, um sie möglichst vielfältigen technischen Anwendungsmöglichkeiten zugänglich zu machen. Stellvertretend für eine Vielzahl von Ausführungsbeispielen und Anwendungsgebieten für derartige Aktor-/Sensor-Systeme sei eine lösungsgemäße Einkapselung eines Piezoaktors erläutert, der zu Zwecken einer adaptiven Schwingungsdämpfung mit einer so genannten Shunt-Impedanz elektrisch verbunden ist, in der mit Hilfe des Piezoaktors in elektrischen Strom gewandelte Schwingungsenergie in Wärme gewandelt wird, um auf diese Weise einem schwingenden System kontrolliert Schwingungsenergie zu entziehen, das infolgedessen schwingungsgedämpft wird. Das lösungsgemäße Verfahren bietet die Möglichkeit, eine derartige adaptive piezoelektrische Schwingungsdämpfungseinheit nach Maßgabe von Form und Größe der Dämpfungseinheit hermetisch mit einem monolithischen Gehäuse zu umkapseln.

Allen voran piezoelektrische Materialien, aber auch andere Wandiermaterialien, die aufgrund ihrer Wandlereigenschaften als Aktoren und/oder Sensoren eingesetzt werden, bedürfen in vorteilhafter Weise einer mechanischen Vorspannung, die zumeist von außen auf den jeweiligen Piezoaktor oder -sensor aufzubringen ist. Eine diesbezügliche Vorspannung kann mit Hilfe des lösungsgemäßen Verfahrens dadurch erzielt und erzeugt werden, dass das Piezoelement während einer lösungsgemäßen Bauprozess-Unterbrechung in das teilgefertigte Gehäusestück eingesetzt und der Bauprozess mit einer bestimmten Prozessführung derart fortgesetzt wird, dass die sich im weiteren ausbildende Gehäusestruktur während ihrer Herstellung und/oder der nachfolgenden Abkühlung thermomechanischen Schrumpfungen unterliegt, womit eine Vorspannung von Seiten der Gehäusestruktur auf das innen liegende, eingehauste Piezoelement wirkt.

Die hierfür erforderliche Prozessführung ist abhängig von der Art des generativen Herstellungsverfahrens zu wählen. Wird beispielsweise als generatives Herstellungsverfahren das selektive Lasersintern von Polyamiden eingesetzt, so kann die Geschwindigkeit der schichtförmigen Materialaufbringung innerhalb der Arbeitsebene und die nachfolgende selektive Aufschmelzung der pulverförmigen Materialschicht variiert, so beispielsweise erhöht oder reduziert werden. Durch geeignete Wahl der Prozessgeschwindigkeit hinsichtlich der sich wiederholenden Schichtabfolgen kann Einfluss auf die Prozesswärme innerhalb des Bauprozesses und damit verbunden Einfluss auf die Ausbildung thermomechanischer Spannungen innerhalb der zu fertigenden Gehäusestruktur genommen werden.

Neben der generativen Herstellungstechnik des Lasersinterns eigenen sich ebenfalls generative Fertigungsverfahren, bei denen pulverförmiges Material schichtweise auf eine Arbeitsebene aufgebracht und mittels selektiven Austragen eines zumeist flüssigen oder pastösen Bindemittels verfestigt wird. Im Falle der Verwendung von metallischem Pulver als Schichtmaterial, ermöglichen Energiestrahldepositionsverfahrens ein lokales Aufschmelzen des schichtförmig ausgetragenen Metallpulvers zum Aufbau einer dreidimensionalen Gehäusestruktur. Unabhängig davon, ob zur Verfestigung des jeweils eingesetzten Schichtmaterials thermische Prozesse zum Einsatz kommen oder nicht, wie im Falle der Zugabe von Bindemittel, ist es möglich zur Initiierung der thermomechanischen Schrumpfung der die wenigstens einen Piezoaktor oder -sensor zumindest teilweise umfassenden Gehäusestruktur, wenigstens eine Wärmequelle einzusetzen, durch die die Gehäusestruktur erwärmt wird. Durch die Erwärmung kann die Gehäusestruktur während ihrer Ausbildung homogen oder aber auch inhomogen erwärmt werden, so dass sich unterschiedlich stark erwärmte Gehäusestrukturbereiche einstellen, die in Abhängigkeit eines darauf folgenden Abkühlprozesses zu mechanischen Spannungen führen, die eine auf den von der Gehäusestruktur umhausten Piezoaktor oder -sensor gerichtete mechanische Vorspannung erzeugen.

Eine für die Erwärmung der Gehäusestruktur bevorzugte Wärmequelle stellt eine innerhalb der Bauplattform integrierte Heizung dar, die für eine einseitige Erwärmung der sich an und über der Bauplattform schichtweise anwachsende Gehäusestruktur sorgt. Die Bauplattform wird gegenüber einer horizontalen Arbeitsebene, in der die pulverförmige Materiaischicht aufgetragen und lokal verfestigt wird, schrittweise abgesenkt, um auf diese Weise zur Bauraum für die sich ausbildende Gehäusestruktur zu schaffen. Als Heizung bieten sich an sich bekannte elektrische Heizelemente an, die die Bauplattform vorzugsweise einheitlich zu temperieren vermögen.

Alternativ oder in Kombination mit einer Bauplattformheizung dient in vorteilhafter Weise eine zusätzliche Wärmequelle, in Form einer Wärmestrahlen emittierenden Quelle, die im Bereich des Bauraumes vorgesehen ist und zumindest Teilbereiche der sich auf der Bauplattform ausbildenden Gehäusestruktur mit Wärmestrahlen beaufschlagt.

Handelt es sich bei dem pulverförmigen Material um elektrisch leitendes Material, bspw. in Form von Metallpulver, so eignet sich eine Induktionsheizung zur Erwärmung der Gehäusestruktur mit dem Ziel thermisch induzierte Spannungen in der Gehäusestruktur hervorzurufen, um den in der Gehäusestruktur verbauten Piezoaktor und/oder -sensor, kurz Piezoelement, mit einer für die Funktionsweise des Piezoelementes erforderlichen mechanischen Vorspannung zu beaufschlagen.

In allen anwendbaren Varianten zur Erwärmung der Gehäusestruktur ist die Art und Weise der Abkühlung der Gehäusestruktur gleichsam wichtig. Die Abkühlung kann mit Hilfe von Kühlmedien erfolgen, die der erhitzten Gehäusestruktur gleichverteilt oder räumlich heterogen zugeführt werden, bspw. durch geeignet am oder in der Gehäusestruktur vorgesehenen Kühlkanälen oder in Form von gasförmigen Kühlmittelströmen, die über geeignet angeordnete Ventilauslässe auf die auf der Bauplattform aufliegenden Gehäusestruktur gerichtet werden. Bedarfsweise kann die Abkühlung durch Eintauchen der Gehäusestruktur in ein abkühlendes Flüssigbad vorgenommen werden.

Die vorstehenden Temperierungstechniken ermöglichen während des Bauprozesses und gleichsam auch nach Beendigung des Bauprozesses eine kontrolliert einstellbare Prozesstemperatur bzw. Temperaturverteilung innerhalb der Gehäusestruktur. Dies ermöglicht den Einsatz von besonders temperaturempfindlichen Baumaterialien, bspw. von geeignet gewählten Metalllegierungen, die eine Phasenumwandlung aus dem kubisch flächenzentriertem (KFZ) Austenit in kubisch raumzentriertes (KRZ) Martensit zeigen und damit einen deutlichem Schrumpfungseffekt von bis zu einigen Prozent unterliegen, da die Packungsdichte im KRZ Atomgitter deutlich höher sein kann. Diese Volumenreduzierung kann deutlich größer als der gewöhnliche thermische Schrumpf sein. Dieser Effekt lässt sich je nach verwendeter Metalllegierung unterschiedlich nutzen. Hierbei sind im Wesentlichen zwei Parameter wichtig. Die so genannte Umwandlungstemperatur (Tu) sowie die Geschwindigkeit mit der die Temperatur unterschritten wird.

Bspw. besitzt eine Nickel-Titan-Legierung eine Phasenumwandlungstemperatur Tu von ca. 100 °C, d.h. bei Unterschreiten von Tu wandelt NiTi die Kristallstruktur von Austenit in Martensit und erfährt hierdurch eine Volumenschrumpfung. Für den Bauprozess für eine aus NiTi bestehende Gehäusestruktur bedeutet dies, dass der Bauprozess mit einer über Tu liegenden Prozesstemperatur durchzuführen ist. Erst nach Beendigung des Bauprozesses gilt es die Gehäusestruktur samt des in dieser umhausten Piezoelemetes unter Tu abzukühlen, wodurch sich der Schrumpf einstellt, der zur mechanischen Vorspannung des Aktor/Sensors innerhalb der Gehäusestruktur führt.

Eine andere Möglichkeit zur Einstellung bzw. Erzeugung einer auf das von einer Gehäusestruktur umkapselten Piezoelement gerichteten Vorspannung sieht die Ausbildung einer elastischen Gehäusewand im Rahmen des generativen Bauprozesses vor, an der innwandig das Piezoelement einseitig anliegend gefügt ist. Eine elastisch geformte Gehäusewand lässt sich beispielsweise mit Hilfe von Filmgelenken oder durch Vorsehen einer faltenbalgartig ausgebildeten Wandstruktur realisieren. Ein konkretes Ausführungsbeispiel ist im Weiteren unter Bezugnahme auf die Ausführungsbeispiele beschrieben. Zur Erzeugung einer das Piezoelement unter Vorspannung versetzenden externen Kraft dient beispielsweise ein am Gehäuse längsbeweglich anbringbares Stellmittel, beispielsweise in Form einer Stellschraube, die mit einer innerhalb des Gehäuses eingebrachten Gewindestruktur in Eingriff bringbar ist und in Kontakt mit der dehnbaren Gehäusewand und damit mittelbar mit dem innen liegenden Piezoelement gebracht werden kann. Sowohl die Gewindestruktur als auch das Stellmittel können im Rahmen des generativen Bauprozesses hergestellt werden.

Alternativ ist es möglich, die Gewindestruktur innerhalb eines zur Gehäusestruktur separaten Bauteils vorzusehen, das bspw. aus einem anderen, vorzugsweise belastungsfähigerem Material besteht als das Baumaterial, aus dem die Gehäusestruktur gefertigt ist. Dieses separate Bauteil lässt sich gleichermaßen im Rahmen einer Bauprozessunterbrechung in die teilgefertigte Gehäusestruktur integrieren. Neben der Funktion der Gewindestruktur zur Ausbildung einer auf das Piezoelement einwirkenden Vorspannung kann die Gewindestruktur auch als Flansch- bzw. Verbindungsstruktur dienen, um die lösungsgemäß ausgebildete Gehäusestruktur an ein übergeordnetes System zu fügen.

Zur Erzeugung der auf das Piezoelement vermittels der Gehäusestruktur einwirkenden Vorspannung kann auch eine während des Bauprozesses auf die Gehäusestruktur gerichtete, äußere Krafteinwirkung dienen, die zu einer mechanischen Deformation, im Sinne einer Dehnung bzw. Streckung der Gehäusestruktur führt und die nach Fertigstellung des Bauprozesses eine materialinhärente, elastische Rückstellkraft generiert, die zu Zwecken der auf das Piezoelement wirkenden mechanischen Vorspannung genutzt wird.
Hierzu ist es erforderlich innerhalb der Gehäusestruktur eine zumindest bereichsweise elastisch verformbare Gehäusewand zu erzeugen, bspw. dass die elastisch verformbare Gehäusewand faltenbalgartig ausgebildet wird und/oder dass die elastisch verformbare Gehäusewand über eine materialinhärente Elastizität verfügt.

Der mechanische äußere Zwang wird, nachdem der Bauprozess für die Implementierung des wenigstens einen Piezoelementes in die halb fertig gestellte Gerüststruktur unterbrochen worden ist, durch eine an die Gehäusestruktur angreifende Kraft erzeugt wird, die mit Hilfe einer seitlich an die faltenbalgartige und/oder elastisch verformbare Gehäusewand wirkenden Druckkraft und/oder mittels einer in Faltenrichtung bzw. in elastischer Verformungsrichtung wirkenden Zugkraft auf die Gehäusestruktur einwirkt.

In umgekehrter Weise zur vorstehenden Deformation der Gehäusestruktur während des Bauprozesses bietet es sich alternativ an, dass das Piezoelement nach der Implementierung in die teilgefertigte Gehäusestruktur einem mechanischem Zwang ausgesetzt wird, durch den das Piezoelement eine Längenverkürzung erfährt, wobei das Piezoelement in diesem verkürzten Längenzustand von der Gehäusestruktur im weiteren Bauprozess zumindest teilweise umfasst wird und hierdurch eine mechanische Vorspannung von Seiten der Gehäusestruktur erfährt. Dies setzt eine längsstabile Gehäusestruktur voraus, die nach Wegfall des auf das Piezoelement gerichteten Zwangs das Piezoelement daran hindert, sich ungehindert zu strecken, so dass das Piezoelement innerhalb der Gehäusestruktur eine der mechanischen Vorspannung entsprechenden Klemmkraft erfährt.

Schließlich kann zur Erzeugung einer mechanischen Vorspannung im vorstehend erläuterten Sinne eine Materialeigenschaft von piezoelektrischen Materialien vorteilhaft genutzt werden.

Piezoaktoren sind polikristaline Bauteile, deren einzelne Zellen, die sogenannten Weiss'schen Bezirke, Dipolmomente aufweisen. Ist ein Aktor polarisiert, so werden durch Anlegen eine elektrischen Feldes ein Großteil der Weiss'schen Bezirke einheitlich räumlich ausgerichtet, was mit einer geringfügigen Längenänderung entlang des angelegten elektrischen Feldes einhergeht. Wird das Feld vom Aktor genommen, verbleiben die einzelnen Zellen teilweise im ausgerichteten und somit im gelängten Zustand, man spricht in diesem Zusammenhang von einer remanenten Polarisierung.

Durch Erwärmen des Aktors über ein aktorspezifisches Temperaturniveau kann die remanente Polarisierung teilweise oder vollständig eliminiert werden. Das hat zur Folge, dass der Aktor wieder auf seine ursprüngliche Länge "schrumpft.

Um diese Eigenschaft lösungsgemäß zu nutzen wird der piezoelektrische Wandlerwerkstoff, d.h. das Piezoelement, vor der Implementierung in die teilgefertigte Gehäusestruktur erwärmt, so dass der piezoelektrische Werkstoff keine nennenswerte remanente Polarisierung aufweist. Erst nach Fertigstellung des Bauprozesses wird das in der Gehäusestruktur integrierte Piezoelement einem elektrischen Feld ausgesetzt, das zur Polarisierung des piezoelektrischen Wandlerwerkstoffes und zu dessen Ausdehnung führt, die eine mechanische Vorspannung von Seiten der Gehäusestruktur auf das eingehauste Piezoelement bewirkt. Da hierbei die Steifigkeit der Gehäusestruktur überwunden werden muss, stellt sich letztlich ein Zustand ein bei dem die Länge des Piezoelements zwischen seiner natürlichen minimalen (depolarisierten) Länge sowie seiner remanent polarisierten Länge liegt. Es kommt zum Kraftschluss zwischen Gehäuse und Aktor und damit zur Vorspannung.

Weitere Ausführungsmöglichkeiten einer lösungsgemäß hergestellten Gehäusestruktur sind der weiteren Beschreibung unter Bezugnahme auf die Ausführungsbeispiele zu entnehmen.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1a, b, c: Sequenzbilddarstellungen zur Beschreibung des Erfindungsgedankens,
- Fig. 2: Ausführungsbeispiel eines lösungsgemäß gekapselten, unter mechanischer Vorspannung stehenden Piezoaktors,
- Fig. 3: weiteres Ausführungsbeispiel eines gekapselten Piezoaktors mit einer Besfestigungsstruktur,
- Fig. 4a bis h: Sequenzbilddarstellungen zur Erläuterung des lösungsgemäßen generativen Bauprozesses mit einer Unterbrechung und Prozessfortführung sowie
- Fig. 5 a,b, c: Faltenbalgartige Gehäusestruktur mit mechanischer Auslenkung.
- Fig. 6 a, b: Faltenbalgartige Gehäusestruktur mit Fluidkanal,
- Fig. 7: Faltenbalgartige Gehäusestruktur mit magnetischen Partikeln sowie
- Fig. 8: Montage eines Presskraft-beaufschlagten Aktor-/Sensorelementes.

### Wege zur Ausführung der Erfindung, gewerbliche Verwendbarkeit

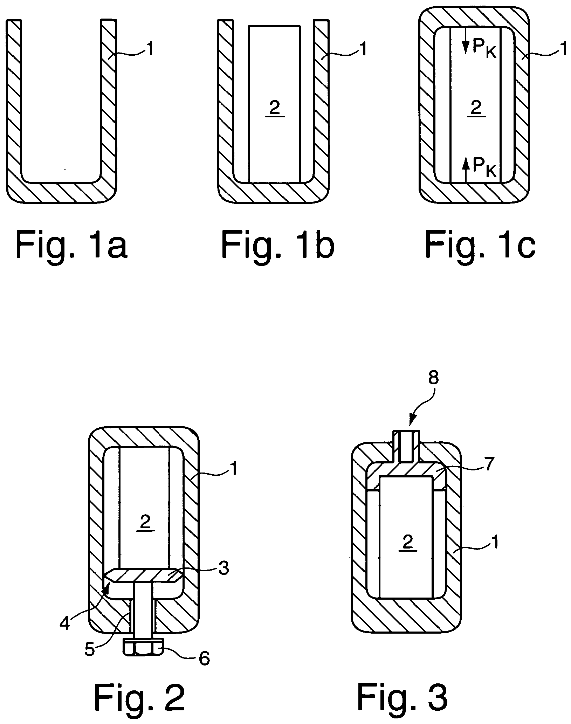

Die Figuren 1a bis c stellen Bildsequenzen dar, anhand derer das Grundprinzip des Verfahrens erläutert werden soll.

In Fig. 1a ist der Längsschnitt einer teilgefertigten Gehäusestruktur 1 illustriert, die im Wege eines generativen Herstellungsverfahrens erzeugt worden ist. Die Form und Größe der Gehäusestruktur 1 liegt als numerischer Datensatz vor, der zur dreidimensionalen Ausgestaltung der Gehäusestruktur dem generativen Hersteilungs- bzw. Fertigungsverfahren zugrunde gelegt wird, Als geeignete Verfahren bieten sich hierzu folgende an sich bekannte generative Fertigungsverfahren an: Rapid Prototyping mittels photolithografischem Verfahren, Fotopolymerisation durch schichtweises Aushärten aus einem Flüssigkeitsbad, schichtweises Auftragen und Verfestigen von Pulverschichten, schichtweises Austragen eines Bindemittels in ein Pulververbund, Energiestrahl-Depositionsverfahren in Metallpulver oder Kunststoffextruder-Techniken, so genannte fused deposition modelling.

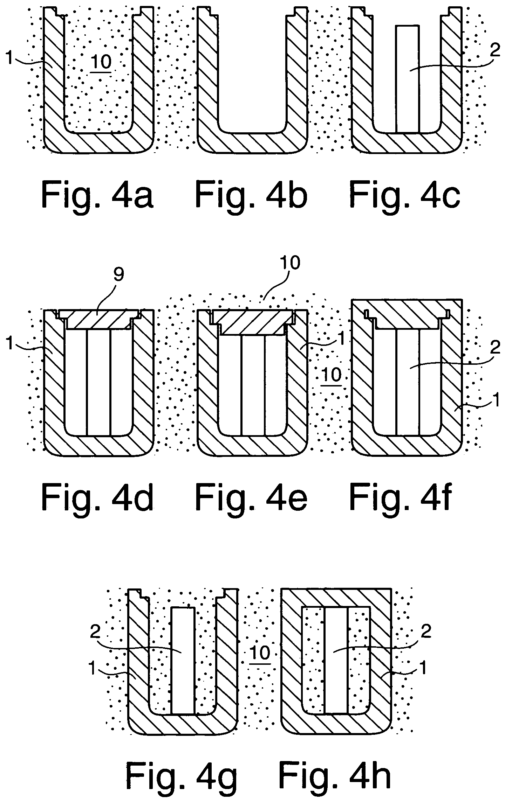

In Fig. 1 a sei angenommen, dass die teilgefertigte Gehäusestruktur 1 topfartig ausgebildet ist, wobei der generative Bauprozess in einem Stadium unterbrochen ist, in dem die topfartige Gehäusestruktur 1 einen von oben freien Zugang bietet. Je nach Wahl des eingesetzten generativen Herstellungsverfahrens gilt es, das während des generativen Bauprozesses nicht verfestigte Material innerhalb der Topfstruktur zu entfernen, beispielsweise mittels selektivem Absaugen, wie dies insbesondere unter Bezugnahme auf die Sequenzbilddarstellungen in den Fig. 4a bis h im Einzelnen erläutert wird.

In der Bildsequenz gemäß Fig. 1b ist in dem nach oben offenen Innenraum der teilgefertigten Gehäusestruktur 1 eine Komponente 2 eingebracht, beispielsweise ein Piezoelement, das aufgrund seiner Energie wandelnden Eigenschaften im Weiteren als Aktor oder Sensor eingesetzt werden kann. Der Piezoeaktor wird vorzugsweise mittels eines adhäsiven Haftvermittlers einseitg am Gehäuseboden fixiert. Nach entsprechender Beschickung der teilgefertigten Gehäusestruktur 1 mit der Komponente 2 wird der generative Bauprozess fortgeführt, indem die nach oben offene, topfförmige teilgefertigte Gehäusestruktur 1 durch Ausbilden eines Deckelabschnittes vollständig geschlossen wird, so dass die Komponente 2 hermetisch von einer monolithisch, d.h. einstückig ausgebildeten Gehäusestruktur umgeben ist (siehe Fig. 1c).

Die Verfahrensweise ermöglicht die einstückige Ausbildung einer Gehäusestruktur, die ein inneres Volumen, vorzugsweise hermetisch vollständig umgibt bzw. abschließt, ohne jegliche Trenn- bzw. Nahtstellen. Eine auf diese Weise gefertigte Gehäusestruktur verfügt aufgrund des Fehlens jeglicher Fügestellen bzw. -flächen über eine außerordentlich hohe Robustheit und Zuverlässigkeit im Hinblick auf einen sicheren und dauerhaften Ab- und Einschluss einer innerhalb der Gehäusestruktur 1 eingebrachten Komponente 2.

Ferner bietet das Verfahren alternativ oder in Kombination mit dem Einbringen wenigstens einer Komponente an oder in die Gehäusestruktur während der Unterbrechung des generativen Bauprozesses die Möglichkeit eine nicht mit dem generativen Bauprozess realisierbare Manipulation an der Gehäusestruktur durchzuführen, indem eine mechanische, thermische, chemische und/oder physikalische Oberflächenbearbeitung an den Innenwandflächen der Gehäusestruktur vorgenommen werden kann. Beispielsweise ist es denkbar, anstelle oder vor Einbringen der Komponente 2 in das Innere der nach oben hin offen ausgebildeten, topfförmigen Gehäusestruktur gemäß Fig. 1a die Innenwand der Gehäusestruktur mit einer Materialschicht im Wege eines physikalischen Beschichtungsprozesses zu beschichten. In gleicher Weise könnte die Gehäuseinnenwand im Wege eines mechanischen Oberflächenbearbeitungsverfahrens poliert, geschliffen oder mittels Fräs-, Bohr- und/oder Schneidtechniken in geeigneter Weise strukturiert werden. Auch ist eine Oberflächenmanipulation im Wege einer thermischen und/oder chemischen Oberflächenbearbeitung denkbar. Nach Beendigung einer derartigen Manipulation der teilgefertigten Gehäusestruktur kann der generative Bauprozess zur Vollendung der Gehäusestruktur entsprechend fortgeführt werden.

Von besonderer Bedeutung im vorliegenden Falle ist die hermetische Umkapselung von aus Wandlermaterialien bestehenden Aktoren und Sensoren. So ist in Verbindung mit der in Fig. 1c illustrierten Ausführungsform bereits erwähnt worden, dass die vollständig umkapselte Komponente 2 ein Piezoelement darstellt, dessen bevorzugte Eigenschaft darin besteht, mechanische Deformationen in elektrische Energie und umgekehrt zu wandeln. In lösungsgemäßer Weise wird der generative Bauprozess zur Einkapselung des Piezoelementes 2 gemäß Bilddarstellung in Fig. 1c derart durchgeführt, so dass die fertig gestellte Gehäusestruktur 1 eine ausschießlich zweiseitig auf das Piezoelement 2 einwirkende Presskraft P_{K} (siehe Pfeildarstellung in Fig. 1 c) ausübt. Eine derartige Presskraft ist realisierbar, indem durch Steuerung der Baugeschwindigkeit, mit der die schichtweise Materialabscheidung und/oder Materialverfestigung erfolgt, die Temperatur der Gehäusestruktur während des Bauprozesses sowie der nachfolgenden Abkühlphase beeinflusst wird, wodurch wiederum thermomechanische Schrumpfungen hervorgerufen werden.

Wird in vorteilhafter Weise das in Fig. 1c dargestellte innen liegende Piezoelement beispielsweise mit einer Shunt-Impedanz verschaltet, die gleichsam zusammen mit dem Piezoelement 2 innerhalb der Gehäusestruktur untergebracht ist, so lässt sich ein vollständig autarkes schwingungsdämpfendes Bauteil realisieren.

Um zu vermeiden, dass beispielsweise Batterie-basierte Ladungsquellen zum Betrieb derartiger Schwingungsdämpfer innerhalb vollständig geschlossener Gehäusestrukturen einzubetten sind und somit die Lebensdauer derartiger Bauteile begrenzen, ist es vorteilhaft, die das schwingungsdämpfende Bauteil umgebene Gehäusestruktur aus Kunststoffmaterial zu fertigen, das beispielsweise im Wege eines selektiven Lasersinterns von Polyamiden verarbeitbar ist. Durch das dielektrische Gehäusematerial kann eine Energieeinkopplung induktiv ohne jegliche Kabeldurchführungen durch die Gehäusestruktur erfolgen. Entsprechende Ausbildungsformen ermöglichen auch den Aufbau vergleichbarer Sensorsysteme.

Auch lassen sich passiv elektronische Schaltungen innerhalb von zumeist aus Kunststoff gefertigten Gehäusestrukturen integrieren, so beispielsweise Near field-Communications-Bauteile (RFID), die für den Plagiatschutz, die Bauteilidentifikation oder Logistikaufgaben, um nur einige technische Anwendungsmöglichkeiten zu nennen, eingesetzt werden können.

In Fig. 2 ist eine alternative Ausführungsform für einen Piezoaktor oder Piezosensor gezeigt, der innerhalb einer vollständig umschlossenen Gehäusestruktur 1 ein Piezoelement 2 umgibt, das sich mit seinem oberen Piezoelementende an der oberen Innenwand der Gehäusestruktur 1 und mit seinem unteren Piezoelementende an einer auslenkbaren Gehäusewand 3 abstützt, die mit der übrigen Gehäuseinnenwand über eine Filmgelenkeinheit 4 einstückig verbunden ist.

Ferner ist in der Gehäusestruktur ein Gewinde 5 eingebracht, in die ein als Schraube ausgebildetes Stellmittel 6 fügbar ist. Je nach Fügetiefe des Stellmittels 6 längs des Gewindes 5 kann eine über die Gehäusewand 3 auf das Piezoelement 2 wirkende Stellkraft zur Schaffung einer mechanischen Vorspannung eingestellt werden.

In Fig. 3 ist ein weiteres Ausführungsbeispiel zu entnehmen, bei dem innerhalb einer Gehäusestruktur 1 ein mechanisch vorgespanntes Piezoelement 2 gelagert ist, dessen oberes Piezoelementende an einem zusätzlich vorgesehenen Bauelement 7 angrenzt bzw. von diesem gefasst ist, das als Zwischenelement zwischen dem Piezoelement 2 und der Gehäusestruktur 1 dient, um beispielsweise während des Bauprozesses eine ausreichende thermische Isolierung zum Piezoelement 2 zu gewährleisten und/oder eine für die spätere Anwendung geeignete mechanische Anbindung zu gewährleisten. So ragt das zusätzliche Bauelement 7 einseitig über die Gehäusewand der Gehäusestruktur 1 hinaus, beispielsweise zur Realisierung einer Befestigungsstruktur im Sinne einer Schraubverbindung. So ist es möglich, über die Befestigungsstruktur 8 die gesamte Gehäusestruktur 1 an ein weiteres mechanisches System anzukoppeln.

Je nach Materialwahl, aus dem die zusätzliche Komponente 7 gefertigt ist, geht diese mit der Gehäusestruktur 1 entweder einen Stoffschluss oder einen Formschluss ein. Ist das zusätzliche Bauelement 7 aus dem gleichen Material gefertigt aus dem auch die Gehäusestruktur besteht, so geht das zusätzliche Element mit dem Gehäuse eine stoffschlüssige Verbindung ein. Andernfalls erfolgt die Verbindung über Formschluss.

In den Bildsequenzdarstellungen gemäß der Figuren 4a bis h sind die Verfahrensschritte zur Durchführung des lösungsgemäßen Verfahrens im Einzelnen dargestellt. So sei in Fig. 4a angenommen, dass die im Wege eines generativen Bauprozesses hergestellte teilgefertigte Gehäusestruktur 1 vollständig in einem Bett aus Pulver 10 vorliegt, wie dies beispielsweise zur generativen Herstellung eines Körpers im Wege des selektiven Lasersinterns unter Verwendung von Metall- oder Polyamid-Pulver der Fall ist. Ferner sei angenommen, dass die teilgefertigte Gehäusestruktur 1 die in Fig. 4a dargestellte Querschnittsform aufweist, die im Übrigen topfförmig ausgebildet ist. Um nun einen Zugang für das Einbringen einer Komponente in den Innenraum der topfförmig ausgebildeten Gefügestruktur 1 zu ermöglichen, gilt es zunächst, das lose und nicht vom Lasersinterverfahren verfestigte Pulvermaterial 10 aus der Topfstruktur zu beseitigen. Mit Hilfe geeigneter Saugtechniken kann der Innenraum der topfförmig ausgebildeten teilgefertigten Gehäusestruktur 1 freigelegt werden, wie dies in Fig. 4b der Fall ist. In Fig. 4c ist eine Komponente 2 in das Innere der teilgefertigten Gefügestruktur 1 eingebracht und vorzugsweise mit ihrem unteren Ende am Bodenbereich der topfförmigen Gehäusestruktur verklebt. In Fig. 4d wird nun das einseitig offene Volumen der topfförmig ausgebildeten teilgefertigten Gehäusestruktur 1 mit einer Deckplatte 9, die aus dem gleichen Material besteht, aus dem auch die Gefügestruktur 1 gefertigt ist, abgeschlossen. Die Deckplatte 9 verfügt über einen zum stufenförmig ausgebildeten Innenrand der Gefügestruktur 1 gegenkonturierten Deckelrand.

Zur Fortführung des generativen Bauprozesses im Rahmen des selektiven Lasersinterns mittels Pulvermaterials wird die Deckelplatte 9 mit einer Schicht von Pulver 10 versehen (siehe Fig. 4e), die nachfolgend durch Laserstrahldeposition in geeigneter Weise verfestigt wird. Auf diese Weise erfolgt ein Anwachsen von verfestigendem Material oberhalb der Deckelplatte 9 (siehe hierzu Fig. 4f). Auf die vorstehende Art und Weise kann die innen liegende Komponente 2 vollständig hermetisch von der Gehäusestruktur 1 umfasst werden, wobei im Inneren der Gehäusestruktur 1 die innen liegende Komponente 2 in einem ansonsten leeren Hohlraum vorliegt.

Eine alternative Prozessabfolge ist in den Sequenzen der Bilder 4g und h dargestellt. Geht man von dem Bauprozessschritt gemäß der Bilddarstellung in Fig. 4c aus, so wird in Abkehr zum Verfahrensschritt gemäß Fig. 4g keine Deckelplatte 9 auf die teilgefertigte Gehäusestruktur 1 gefügt, sondern der von Pulver 10 entleerte Hohlraum der topfförmigen Gehäusestruktur 1 wird vollständig mit dem Pulvermaterial 10 des Bauprozesses verfüllt, so dass die in die Gehäusestruktur 1 eingesetzte Komponente 2 vollständig von losem Pulvermaterial 10 umgeben ist. Die Fortführung des generativen Bauprozesses erfolgt auf konventionelle Art und Weise, wobei jene Pulverschichtbereiche verfestigt werden, die vom Laserstrahl belichtet werden. Auf diese Weise bildet sich eine sich über der Komponente 1 anwachsende Gehäusewand aus, die jedoch im Unterschied zur Bildsequenz gemäß Fig. 4f ein innen liegendes Gehäusevolumen umschließt, das neben der eingebrachten Komponente 2 das lose Pulvermaterial 10 enthält.

Um bereits während des Bauprozesses in der Gehäusestruktur mechanische Spannungen zu generieren, die nach Fertigstellung der Gehäusestruktur zu einer auf die von der Gehäusestruktur umgebenden Komponente 2 als mechanische Vorspannung lastet, bedarf es spezieller Vorkehrungen, die es bei der Durchführung des Bauprozesses zu berücksichtigen gilt.

Eine erste Möglichkeit gezielt mechanische Spannungen in die Gehäusestruktur einzubringen betrifft den Eintrag thermischer Energie in die sich ausbildende Gehäusestruktur, die entweder mittels eines Laserstrahls oder eines vergleichbaren Energieeintrages, der je nach Bauprozess, Teil des Bauprozesses selbst ist, bspw. im Falles des generativen Lasersinterns, oder mittels einer Heizquelle, die am oder im Bauraum separat vorzusehen ist, erzeugt wird. Durch einen dosiert vorgegebenen thermischen Energieeintrag in die Gehäusestruktur können materialbedingte mechanische Spannungen innerhalb der Gehäusestruktur erzeugt werden.

Eine zweite Möglichkeit stellt die Konservierung einer während des Bauprozesses auf die Gehäusestruktur einwirkenden Kraft dar, die zumindest teilweise nach Fertigstellung der Gehäusestruktur in Form einer auf die von der Gehäusestruktur umschlossenen Komponente als Klemmkraft wirkt.

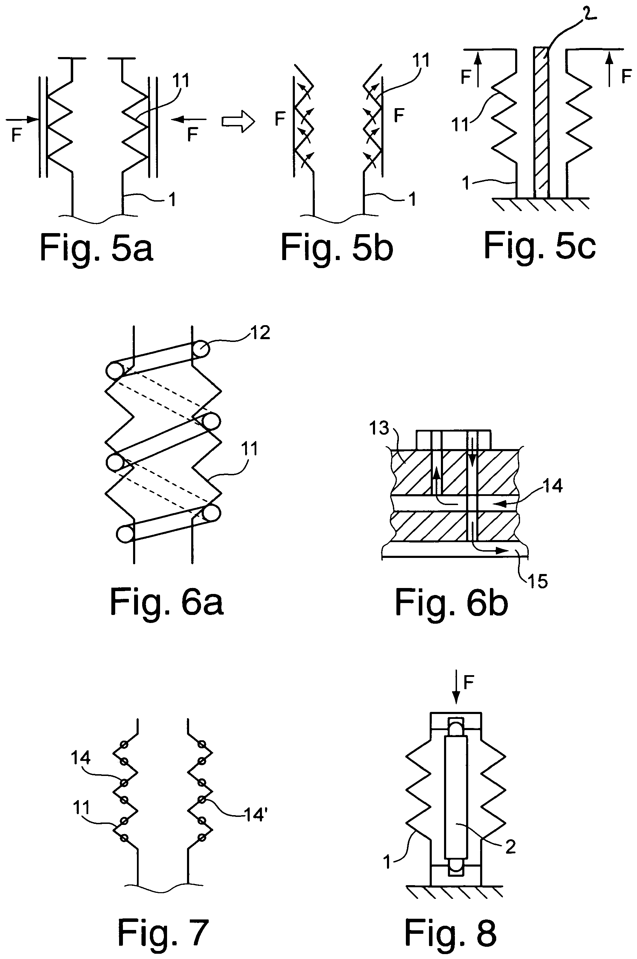

Figur 5 a zeigt hierzu ein Ausführungsbeispiel, bei dem die Gehäusestruktur 1 über einen faltenbalgartig ausgebildeten Teilbereich 11 verfügt, der aufgrund seiner Faltenstruktur längs einer Raumrichtung kraftunterstützt F gestreckt werden kann. Im dargestellten Fall, siehe Figur 5b, greift seitlich an der Gehäusestruktur 1 eine Kraft F an, die das Gehäuse in eine gestreckte Form überführt.

Alternativ ist es ebenso möglich die Kraft F in Raumrichtung, längs der sich die Faltenstruktur 11 auszudehnen vermag, an der Gehäusestruktur 1 angreifen zu lassen, siehe Figur 5c.

In dem kraftunterstützt, ausgelenkten Fall wird die Komponente 2, in Form eines Piezoelementes, in die Gehäusestruktur 1 eingesetzt und nachfolgend durch Fortführung des generativen Bauprozesses durch Ausbilden eines oberen Deckelteils von der Gehäusestruktur fest umschlossen, sodass nach Beendigung des Bauprozesses und der damit verbundenen Krafteinwirkung eine mechanische Vorspannung auf das Piezoelement 2 lastet, die von der durch die faltenbalgartig ausgebildete Wandstruktur und der in dieser wirkenden materialinhärenten elastischen Rückstellkraft herrührt.

Alternativ zur mechanisch unterstützen Auslenkung des faltenbalgartig ausgebildeten Teilbereiches 11 der Gehäusestruktur 1 kann die Auslenkung durch thermischen Energieeintrag bewerkstelligt werden. Hierzu wird im Rahmen des generativen Herstellungsverfahrens gemeinsam mit der faltenbalgartigen Ausbildung der Gehäusestruktur eine Rohrleitung 12 ausgebildet, siehe Figur 6 a, die den faltenbalgartig ausgebildeten Teilbereich 11 wendelartig umgibt und mit diesem einstückig verbunden ist. Die Rohrleitung 12 dient als Fluidkanal, durch den ein flüssiges oder gasförmiges Kühl- oder Erwärmungsmedium hindurchgeleitet werden kann. Im Falle eines heissen Mediums dehnt sich der faltenbalgartige Teilbereich 11 aus im Falle eins Kühlmediums zieht sich der Bereich zusammen.

Eine Zu- und Abführung des Kühl- oder Erwärmungsmediums durch die Rohrleitung 12 erfolgt über eine speziell modifizierte Bauplattform 13, siehe Figur 6b, auf der die Gehäusestruktur 1 durch schichtförmige Materialabscheidung- und -verfestigung ausgebildet wird. Die Bauplattform 13 weist ein integriertes Hohlleitungssystem auf, das über einen Zulauf 14 und einen Ablauf 15 verfügt. Mit Hilfe einer derartigen thermischen Einflussnahme kann der faltenbalgartige Teilbereich 11 durch eine entsprechende Erwärmung in einen ausgedehnten, d.h. gestreckten Zustand überführt werden, in dem das Piezoelement 2 in die Gehäusestruktur implementiert werden kann. In gleicher Weise wie im vorstehenden Fall mit mechanisch unterstützter Auslenkung, jedoch unbeeinträchtigt von jeglicher den mechanischen Zwang realisierenden Anordnung, wird der generative Bauprozess fortgesetzt um durch Einschluss des Piezoelementes 2 die mechanische Vorspannung zu erhalten, die von der durch die faltenbalgartig ausgebildete Wandstruktur und der in dieser wirkenden materialinhärenten elastischen Rückstellkraft herrührt, sobald die Rohrleitung 12 von der Zufuhr von dem Erwärmungsmedium abgekoppelt wird und sich somit die Gehäusestruktur 1 abkühlt und sich zusammenziehen vermag. Die Abkühlung kann beschleunigt bzw. unterstützt werden, indem durch die Rohleitung 12 ein Kühlmedium gefördert wird.

Figur 7 zeigt eine Ausbildungsvariante eines faltenbalgartig ausgebildeten Teilbereiches 11 der Gehäusestruktur 1, in dem magnetische Partikel 14 eingebracht sind, die in Wechselwirkung mit einem externen Magnetfeld eine den faltenbalgartig ausgebildeten Teilbereich 11 in entsprechender Weise auszulenken vermögen. Andererseits kann bei Verwendung von elektrisch leitfähiger Partikel 14', die in das Material, aus dem zumindest der faltenbalgartige Teilbereich 11 gefertigt ist, im Wege einer induktiven Erwärmung, ebendieser Teilbereich erwärmt werden, wodurch sich ebenfalls eine räumliche Streckung der Gehäusestruktur einstellt, die in der vorstehend beschriebenen Weise genutzt werden kann

Schließlich sei in Verbindung mit dem in Figur 8 illustrierten Ausführungsbeispiel auf die Möglichkeit verwiesen das Piezoelement 2 Presskraft beaufschlagt zu komprimieren und in diesem Zustand in die teilgefertigte Gehäusestruktur 1 einzusetzen. Die mechanische Kompression wird solange aufrecht erhalten, bis das Piezoelement 2 beidseitig von der Gehäusestruktur 1 umschlossen ist, so dass die durch die Entspannung des Piezoelementes 2 herrührende Längenzunahme von der Gehäusestruktur behindert wird, wodurch sich eine mechanische Vorspannung ausbildet.

### Bezugszeichenliste

- 1: Gehäusestruktur
- 2: Komponente, Piezoelement
- 3: Auslenkbare Gehäusewand
- 4: Filmgelenk
- 5: Gewinde
- 6: Stellglied, Schraube
- 7: Separates Bauelement
- 8: Befestigungsstruktur
- 9: Deckelelement
- 10: Pulver
- 11: Faitenbaigartiger Teilbereich
- 12: Rohrleitung
- 13: Bauplattform
- 14: Magnetische Partikel

## Patentansprüche

1. Verfahren zur Herstellung einer wenigstens eine Komponente zumindest teilweise umschließenden Gehäusestruktur, wobei die Gehäusestruktur im Rahmen eines durch wiederholtes schichtweises Abscheiden und/oder Verfestigen von Material geprägten Bauprozesses hergestellt wird, der vor Fertigstellung der Gehäusestruktur wenigstens einmalig unterbrochen wird, und während der einen Unterbrechung an oder in die teilgefertigte Gehäusestruktur die wenigstens eine Komponente gefügt wird, die nicht mit dem Bauprozess hergestellt ist und als zumindest ein teilweise aus einem Wandlerwerkstoff bestehendes Aktor- und/oder Sensorelement gewählt wird, und im Anschluss an die eine Unterbrechung der Bauprozess fortgesetzt wird, bis das Gehäuse, das die wenigstens eine Komponente zumindest teilweise umfasst, fertig gestellt ist,
**dadurch gekennzeichnet, dass** während und/oder nach dem Bauprozess Teilbereiche der sich ausbildenden oder ausgebildeten Gehäusestruktur lokal erwärmt oder gekühlt werden zur Initiierung einer thermomechanischen Schrumpfung der die wenigstens eine Komponente zumindest teilweise umfassenden Gehäusestruktur derart, dass eine mechanische Vorspannung in Form einer ausschließlich zweiseitig entgegen gerichteten, von Seiten der Gehäusestruktur auf das eingehauste Aktor- und/oder Sensorelement einwirkenden Presskraft (P_{K}) wirkt.

2. Verfahren nach Anspruch 1,
**dadurch gekennzeichnet, dass** der Bauprozess im Rahmen eines generativen Fertigungsverfahrens durchgeführt wird, bei dem pulverförmiges Material schichtweise auf eine Arbeitsebene aufgebracht und mittels selektiven Lasersintern verfestigt wird, bei dem zur Initiierung der thermomechanischen Schrumpfung der die wenigstens eine Komponente zumindest teilweise umfassenden Gehäusestruktur, die Geschwindigkeit variiert wird, mit der jeweils eine schichtförmige Materialschicht aus pulverförmigen Material innerhalb einer Arbeitsebene aufgebracht wird und eine nachfolgende Aufschmelzung der pulverförmigen Materialschicht erfolgt.

3. Verfahren nach Anspruch 1,
**dadurch gekennzeichnet, dass** der Bauprozess im Rahmen eines generativen Fertigungsverfahrens durchgeführt wird, bei dem pulverförmiges Material schichtweise auf eine Arbeitsebene aufgebracht und mittels selektiven Lasersintern, selektiven Austragen eines Bindemittels oder mittels eines Energiestrahldepositionsverfahrens verfestigt wird, bei dem zur Initiierung der thermomechanischen Schrumpfung der die wenigstens eine Komponente zumindest teilweise umfassenden Gehäusestruktur, wenigstens eine Wärmequelle eingesetzt wird, durch die die Gehäusestruktur erwärmt wird.

4. Verfahren nach einem der Ansprüche 1 bis 3,
**dadurch gekennzeichnet, dass** als pulverförmiges Material ein Metall oder eine Metalllegierung verwendet wird, das eine Phasenumwandlung bei Unterschreiten einer Phasenumwandlungstemperatur von einem kubisch flächenzentriertem Austenit in ein kubisch raumzentrierten Martensit derart vollzieht, so dass das Material während des Bauprozesses über der Phasenumwandlungstemperatur liegt und dass nach Abschluss des Bauprozesses die Gerüststruktur unter die Phasenumwandlungstemperatur abgekühlt wird.

5. Verfahren nach Anspruch 4,
**dadurch gekennzeichnet, dass** als pulverförmiges Material eine Nickel-Titan-Legierung gewählt wird.

6. Verfahren nach einem der Ansprüche 1 bis 5,
**dadurch gekennzeichnet, dass** die Gehäusestruktur derart ausgebildet wird, dass die Gehäusestruktur zumindest bereichsweise eine elastisch verformbare Gehäusewand aufweist, längs der zumindest abschnittsweise wenigstens eine mit der Gehäusewand verbundene Hohlleitung verläuft, und
dass die Hohlleitung fluiddicht mit einem Zu- und Abfluss verbunden ist, über die ein Medium durch die Hohlleitung strömt.

7. Verfahren nach Anspruch 6,
**dadurch gekennzeichnet, dass** der Zu- und Abfluss in einer Bauplattform integriert werden, auf der die Gehäusestruktur schichtweise aufgebaut wird, und
dass das Medium derart gewählt wird, dass die elastisch verformbare Gehäusewand während des weiteren Bauprozesses eine Streckung und/oder nach Abschluss des Bauprozesses eine Stauchung erfährt.

8. Verfahren zur Herstellung einer wenigstens eine Komponente zumindest teilweise umschließenden Gehäusestruktur, wobei die Gehäusestruktur im Rahmen eines durch wiederholtes schichtweises Abscheiden und/oder Verfestigen von Material geprägten Bauprozesses hergestellt wird, der vor Fertigstellung der Gehäusestruktur wenigstens einmalig unterbrochen wird, und während der einen Unterbrechung an oder in die teilgefertigte Gehäusestruktur die wenigstens eine Komponente gefügt wird, die nicht mit dem Bauprozess hergestellt ist und als zumindest ein teilweise aus einem Wandlerwerkstoff bestehendes Aktor- und/oder Sensorelement gewählt wird, und im Anschluss an die eine Unterbrechung der Bauprozess fortgesetzt wird, bis das Gehäuse, das die wenigstens eine Komponente zumindest teilweise umfasst, fertig gestellt ist,
**dadurch gekennzeichnet, dass** die Gehäusestruktur derart ausgebildet wird, dass die Gehäusestruktur zumindest bereichsweise eine elastisch verformbare Gehäusewand aufweist,
dass im Anschluss an die eine Unterbrechung ein mechanischer Zwang auf die Gehäusestruktur derart einwirkt, so dass die elastisch verformbare Gehäusewand gestreckt wird, und dass nach Fertigstellung der Gehäusestruktur der mechanische Zwang entfernt und die Streckung der elastisch verformbare Gehäusewand durch eine materialinhärent wirkende, elastische Rückstellkraft zumindest teilweise reduziert wird, so dass eine mechanische Vorspannung von Seiten der Gehäusestruktur auf das eingehauste Aktor- und/oder Sensorelement derart wirkt, dass die mechanische Vorspannung in Form einer ausschließlich zweiseitig entgegen gerichteten, von Seiten der Gehäusestruktur auf das eingehauste Aktor- und/oder Sensorelement einwirkenden Presskraft (P_{K}) wirkt.

9. Verfahren nach Anspruch 8,
**dadurch gekennzeichnet, dass** der mechanische Zwang durch eine an die Gehäusestruktur angreifende externe Kraft erzeugt wird, die mit Hilfe einer seitlich an die elastisch verformbare Gehäusewand wirkenden Druckkraft und/oder mittels einer Zugkraft auf die Gehäusestruktur einwirkt.

10. Verfahren zur Herstellung einer wenigstens eine Komponente zumindest teilweise umschließenden Gehäusestruktur, wobei die Gehäusestruktur im Rahmen eines durch wiederholtes schichtweises Abscheiden und/oder Verfestigen von Material geprägten Bauprozesses hergestellt wird, der vor Fertigstellung der Gehäusestruktur wenigstens einmalig unterbrochen wird, und während der einen Unterbrechung an oder in die teilgefertigte Gehäusestruktur die wenigstens eine Komponente gefügt wird, die nicht mit dem Bauprozess hergestellt ist und als zumindest ein teilweise aus einem Wandlerwerkstoff bestehendes Aktor- und/oder Sensorelement gewählt wird, und im Anschluss an die eine Unterbrechung der Bauprozess fortgesetzt wird, bis das Gehäuse, das die wenigstens eine Komponente zumindest teilweise umfasst, fertig gestellt ist,
**dadurch gekennzeichnet, dass** als die wenigstens eine an oder in die Gehäusestruktur zu fügende Komponente ein zumindest teilweise aus einem piezoelektrischen Wandlerwerkstoff bestehendes Aktor- und/oder Sensorelement gewählt wird,
dass der piezoelektrische Wandlerwerkstoff vor der Implementierung in die teilgefertigte Gehäusestruktur erwärmt wird, so dass der piezoelektrische Werkstoff keine nennenswerte remanente Polarisierung aufweist,
dass das zumindest teilweise aus dem piezoelektrischen Wandlerwerkstoff bestehende Aktor- und/oder Sensorelement nach Fertigstellung des Bauprozesses einem elektrischen Feld ausgesetzt wird, das zur Polarisierung des piezoelektrischen Wandlerwerkstoffes und zu dessen Ausdehnung führt, die eine mechanische Vorspannung von Seiten der Gehäusestruktur auf das eingehauste Aktor- und/oder Sensorelement derart bewirkt, dass die mechanische Vorspannung in Form einer ausschließlich zweiseitig entgegen gerichteten, von Seiten der Gehäusestruktur auf das eingehauste Aktor- und/oder Sensorelement einwirkenden Presskraft (P_{K}) wirkt.

11. Verfahren zur Herstellung einer wenigstens eine Komponente zumindest teilweise umschließenden Gehäusestruktur, wobei die Gehäusestruktur im Rahmen eines durch wiederholtes schichtweises Abscheiden und/oder Verfestigen von Material geprägten Bauprozesses hergestellt wird, der vor Fertigstellung der Gehäusestruktur wenigstens einmalig unterbrochen wird, und während der einen Unterbrechung an oder in die teilgefertigte Gehäusestruktur die wenigstens eine Komponente gefügt wird, die nicht mit dem Bauprozess hergestellt ist und als zumindest ein teilweise aus einem Wandlerwerkstoff bestehendes Aktor- und/oder Sensorelement gewählt wird, und im Anschluss an die eine Unterbrechung der Bauprozess fortgesetzt wird, bis das Gehäuse, das die wenigstens eine Komponente zumindest teilweise umfasst, fertig gestellt ist,
**dadurch gekennzeichnet, dass** das Aktor- und/oder Sensorelement nach der Implementierung in die teilgefertigte Gehäusestruktur einem mechanischem Zwang ausgesetzt wird, durch den das Aktor- und/oder Sensorelement eine Längenverkürzung erfährt, und dass das Aktor- und/oder Sensorelement in diesem verkürzten Längenzustand von der Gehäusestruktur zumindest teilweise umfasst wird und hierdurch eine mechanische Vorspannung von Seiten der Gehäusestruktur derart erfährt, dass die mechanische Vorspannung in Form einer ausschließlich zweiseitig entgegen gerichteten, von Seiten der Gehäusestruktur auf das eingehauste Aktor- und/oder Sensorelement einwirkenden Presskraft (P_{K}) wirkt.

12. Verfahren nach einem der Ansprüche 1 bis 11,
**dadurch gekennzeichnet, dass** vor oder nach der Unterbrechung des Bauprozesses und vor Fertigstellung der Gehäusestruktur wenigstens eine weitere Unterbrechung des Bauprozesses vorgenommen wird, während der an oder in die teilgefertigte Gehäusestruktur wenigstens eine weitere Komponente gefügt wird und/oder an der teilgefertigten Gehäusestruktur eine Manipulation in Form einer mechanischen, thermischen, chemischen und/oder physikalischen Oberflächenbearbeitung an der teilgefertigten Gehäusestruktur, vorgenommen wird, die im Rahmen des Bauprozesses nicht durchführbar ist, und dass nachfolgend der Bauprozess fortgeführt wird.

13. Gehäusestruktur, die wenigstens eine Komponente zumindest teilweise umschließt, hergestellt mit einem Verfahren nach einem der Ansprüche 1 bis 12,
**dadurch gekennzeichnet, dass** als die wenigstens eine an oder in die Gehäusestruktur zu fügende Komponente ein zumindest teilweise aus einem Wandlerwerkstoff bestehendes Aktor- und/oder Sensorelement ist,
dass die Gehäusestruktur die wenigstens eine Komponente monolithisch umfasst, dass die wenigstens eine Komponente mit der Gehäusestruktur form- oder stoffschlüssig oder mittels adhäsivem Haftvermittler gefügt ist.

14. Gehäusestruktur nach Anspruch 13,
**dadurch gekennzeichnet, dass** die Gehäusestruktur wenigstens eine auslenkbare Gehäusewand aufweist, an deren Gehäuseinnenwand die wenigstens eine Komponente gefügt ist, und dass die Gehäusestruktur ein Gegenlager aufweist, an dem sich ein Spannmittel abstützt, das einseitig mit der auslenkbaren Gehäusewand in Wirkverbindung bringbar ist.

15. Gehäusestruktur nach einem der Ansprüche 13 bis 14,
**dadurch gekennzeichnet, dass** wenigstens eine weitere Komponente vorgesehen ist, die aus einem Material gefertigt ist, das härter als das Material ist, aus dem die Gehäusestruktur besteht, und
dass die weitere Komponente einen in das Gehäuseinnere ragenden Abschnitt aufweist, der mit der wenigstens einen Komponente zumindest in Kontakt steht, sowie einen außerhalb der Gehäusestruktur ragenden Abschnitt aufweist, der eine Befestigungsstruktur aufweist.

16. Gehäusestruktur nach Anspruch 13,
**dadurch gekennzeichnet, dass** die Gehäusestruktur zumindest in Teilbereichen eine elastisch verformbar ausgebildete Gehäusewand aufweist, die längs einer Raumachse biaxial auslenkbar ist, dass das Aktor- und/oder Sensorelement eine aktorische und/oder sensorische Wirkrichtung aufweist, die parallel zu der Raumachse orientiert ist, längs der das Aktor- und/oder Sensorelement eine mechanische Vorspannung von Seiten der Gehäusestruktur erfährt.

## Claims

1. Method for producing a housing structure at least partially enclosing at least one component, wherein the housing structure is produced by a construction process **characterized by** repeated layered elimination and/or solidification of material, which is interrupted at least once before completion of the housing structure, and during said interruption the at least one component, which is not produced by the construction process and is chosen as at least one actuator and/or sensor element consisting partially of a transformer material, is joined to or in the partially finished housing structure, and the construction process is then continued following the one interruption until the housing which at least partially comprises the at least one component is completed,
**characterized in that** partial regions of the forming or formed housing structure are heated or cooled locally during and/or after the construction process to initiate a thermomechanical shrinking of the housing structure at least partially comprising the at least one component, so that a mechanical pre-tension is exerted in the form of a pressing force (PK) acting exclusively in two opposing directions on the enclosed actuator and/or sensor element by the housing structure.

2. Method according to Claim 1,
**characterized in that** the construction process is carried out as part of a generative production method in which powder material is deposited in layers on a working plane and solidified by selective laser sintering, in which the speed with which each material layer of powder material is deposited within the working plane to initiate the thermomechanical shrinkage of the housing structure at least partially enclosing the at least one component is varied, and the powder material layer is subsequently melted.

3. Method according to Claim 1,
**characterized in that** the construction process is carried out as part of a generative production method in which powder material is deposited in layers on a working plane and is solidified by selective laser sintering, selective spreading of a binding agent, or by an energy beam deposition method in which at least one heat source by which the housing structure is heated is applied to initiate the thermomechanical shrinkage of the housing structure at least partially enclosing the at least one component.

4. Method according to any one of Claims 1 to 3,
**characterized in that** a metal or metal alloy is used as powder material, which metal or metal alloy undergoes a phase transition from a face-centred cubic austenite to a body-centred cubic martensite when the temperature thereof falls below a phase transition temperature in such manner that the material temperature is above the phase transition temperature during the construction process and the matrix structure is cooled to below the phase transition temperature after the construction process is completed.

5. Method according to Claim 4,
**characterized in that** a nickel-titanium alloy is selected as powder material.

6. Method according to any one of Claims 1 to 5,
**characterized in that** the housing structure is constructed such that at least an area of the housing structure includes an elastically deformable housing wall along at least sections of which at least one hollow guide connected to the housing wall extends, and
that the hollow guide is connected in fluid-tight manner to an inflow and drain, via which a medium flows through the hollow guide.

7. Method according to Claim 6,
**characterized in that** the inflow and the drain are integrated in a construction platform on which the housing structure is constructed in layers, and
that the medium is selected such that the elastically deformable housing wall undergoes stretching during the further construction process and/or compression after completion of the construction process.

8. Method for producing a housing structure at least partially enclosing at least one component, wherein the housing structure is produced by a construction process **characterized by** repeated layered elimination and/or solidification of material, which is interrupted at least once before completion of the housing structure, and during said interruption the at least one component, which is not produced by the construction process and is chosen as at least one actuator and/or sensor element consisting partially of a transformer material, is joined to or in the partially finished housing structure, and the construction process is then continued following the one interruption until the housing which at least partially comprises the at least one component is completed,
**characterized in that** the housing structure is constructed such that at least an area of the housing structure includes an elastically deformable housing wall,
that following the one interruption a mechanical pressure acts on the housing structure in such manner that the elastically deformable housing wall is distended, and that after production of the housing structure the mechanical pressure is removed and the distension of the elastically deformable housing wall is at least partially reduced by an elastic restoring force with action inherent in the material, so that a mechanical pre-tension is exerted by the housing structure on the actuator and/or sensor element accommodated therein in such manner that the mechanical pre-tension is exerted in the form of a pressing force (PK) acting exclusively in two opposing directions on the enclosed actuator and/or sensor element by the housing structure.

9. Method according to Claim 8,
**characterized in that** the mechanical pressure is generated by an external force exerted on the housing structure which acts with the aid of a compressive force directed laterally against the elastically deformable housing wall and/or by means of a tensile force on the housing structure.

10. Method for producing a housing structure at least partially enclosing at least one component, wherein the housing structure is produced by a construction process **characterized by** repeated layered elimination and/or solidification of material, which is interrupted at least once before completion of the housing structure, and during said interruption the at least one component, which is not produced by the construction process and is chosen as at least one actuator and/or sensor element consisting partially of a transformer material, is joined to or in the partially finished housing structure, and the construction process is then continued following the one interruption until the housing which at least partially comprises the at least one component is completed,
**characterized in that** an actuator and/or sensor element consisting at least partially of a piezoelectric transformer material is selected as the at least one component to be joined to or in the housing structure,
that the piezoelectric transformer material is heated before implementation in the partially finished housing structure, with the result that the piezoelectric material has no significant remanent polarisation,
that after completion of the construction process the actuator and/or sensor element consisting at least partially of the piezoelectric transformer material is exposed to an electrical field, which results in the polarisation of the piezoelectric transformer material
and expansion thereof, causing a pre-tension by the housing structure on the encased actuator and/or sensor element in such manner that the mechanical pre-tension is exerted in the form of a pressing force (PK) acting exclusively in two opposing directions on the enclosed actuator and/or sensor element by the housing structure.

11. Method for producing a housing structure at least partially enclosing at least one component, wherein the housing structure is produced by a construction process **characterized by** repeated layered elimination and/or solidification of material, which is interrupted at least once before completion of the housing structure, and during said interruption the at least one component, which is not produced by the construction process and is chosen as at least one actuator and/or sensor element consisting partially of a transformer material, is joined to or in the partially finished housing structure, and the construction process is then continued following the one interruption until the housing which at least partially comprises the at least one component is completed,
**characterized** after implementation in the partially finished housing structure the actuator and/or sensor element is exposed to a mechanical pressure as a result of which the actuator and/or sensor element undergoes a shortening of length, and that in this state of shortened length the actuator and/or sensor element is at least partially enclosed by the housing structure and is thereby subjected to a mechanical pre-tension by the housing structure in such manner that the mechanical pre-tension is exerted in the form of a pressing force (PK) acting exclusively in two opposing directions on the enclosed actuator and/or sensor element by the housing structure.

12. Method according to any one of Claims 1 to 11,
**characterized in that** at least one further interruption is carried out before or after the interruption of the construction process and before the housing is completed, during which further interruption at least one additional component is inserted in or disposed on the partially finished housing structure and/or a manipulation in the form of a mechanical, thermal, chemical and/or physical surface treatment which cannot be performed as part of the construction process is carried out on the partially finished housing structure, and that the construction process is resumed afterwards.

13. Housing structure at least partially enclosing at least one component, produced with a method according to any one of Claims 1 to 12,
**characterized in that** an actuator and/or sensor element consisting at least partially of a transformer material is selected as the at least one component to be joined to or in the housing structure,
that the housing structure encloses the at least one component monolithically,
that the at least one component is joined to the housing structure in form-fitting or force-fitting manner or by means of an adhesive bonding agent.

14. Housing structure according to Claim 13,
**characterized in that** the housing structure comprises at least one deflectable housing wall, and the at least one component is joined to the housing inner wall thereof, and that the housing structure has a counter-bearing against which a tensioning means is braced, which means can be brought into operative connection with the deflectable housing wall on one side.

15. Housing structure according to either of Claims 13 or 14,
**characterized in that** at least one further component is provided, which component is produced from a material that is harder than the material of which the housing structure is made, and
that the at least one further component has a section which protrudes into the housing interior, which section is in contact with the at least one component, and has section which protrudes outside of the housing structure, which has a fastening structure.

16. Housing structure according to Claim 13,
**characterized in that** at least subareas of the housing structure include a housing wall which is designed to be elastically deformable and is biaxially deflectable along a spatial axis, that the actuator and/or sensor element has an actuating and/or sensory operating direction which is aligned parallel to the spatial axis along which the actuator and/or sensor element is subjected to a mechanical pre-tensioning by the housing.

## Revendications

1. Procédé de fabrication d'une structure de boîtier entourant au moins partiellement au moins un composant, dans lequel la structure de boîtier est fabriquée dans le cadre d'un processus de construction **caractérisé par** une découpe par couches répétée et/ou une solidification du matériau, qui avant la fabrication de la structure de boîtier est interrompue au moins une fois, et pendant l'interruption au moins un composant est assemblé sur ou dans la structure de boîtier partiellement fabriquée, qui n'est pas fabriqué avec le processus de fabrication et sélectionné comme au moins un élément d'actionneur et/ou de capteur constitué partiellement d'un matériau convertisseur, et à la suite de l'interruption le processus de construction est poursuivi, jusqu'à ce que le logement, qui comprend au moins partiellement au moins un composant, soit considéré comme fini,
**caractérisé en ce que** pendant et/après le processus de construction des zones partielles de la structure de boîtier réalisée ou en cours de réalisation sont chauffées ou refroidies localement pour lancer une contraction thermomécanique de la structure de boîtier comprenant au moins partiellement au moins un composant de telle sorte qu'une précontrainte mécanique s'exerce sous la forme d'une force de pressage, (Pk) agissant exclusivement des deux cotés en sens contraire, à partir des côtés de la structure de boîtier sur l'élément d'actionneur et/ou de capteur encastré.

2. Procédé selon la revendication 1,
**caractérisé en ce que** le processus de construction est effectué dans le cadre d'un procédé de fabrication génératif, dans lequel un matériau poudreux est appliqué par couches sur un plan de travail et solidifié au moyen d'un frittage au laser sélectif, dans lequel lors du lancement de la contraction thermomécanique de la structure de boîtier comprenant au moins partiellement au moins un composant, la vitesse est variée, avec laquelle respectivement une couche d'un matériau en couches constitué d'un matériau poudreux est appliquée à l'intérieur d'un plan de travail et une fusion subséquente de la couche de matériaux poudreux a lieu.

3. Procédé selon la revendication 1,
**caractérisé en ce que** le processus de construction est effectué dans le cadre d'un procédé de fabrication génératif, dans lequel un matériau poudreux est appliqué par couches sur le plan de travail et solidifié au moyen d'un frittage au laser sélectif, d'une application sélective d'un agent liant ou au moyen d'un procédé de dépôt par rayonnement énergétique, dans lequel pour lancer la contraction thermomécanique d'une structure de boîtier comprenant au moins partiellement au moins un composant, au moins une source de chaleur est employée, par l'intermédiaire de laquelle la structure de boîtier est chauffée.

4. Procédé selon une des revendications 1 à 3,
**caractérisé en ce que** comme matériau poudreux un métal ou un alliage de métaux est employé, qui exécute une conversion de phase en cas de dépassement d'une température de conversion de phase d'une austénite cubique à face centrée en une martensite cubique à face centrée, de sorte qu'un matériau se trouve pendant le processus de construction au-dessus de la température de conversion de phase et après la fin de construction la structure de bâti est refroidie au-dessous de la température de conversion de phase.

5. Procédé selon la revendication 4,
**caractérisé en ce que** comme matériau poudreux un alliage nickel-titane est sélectionné.

6. Procédé selon une des revendications 1 à 5,
**caractérisé en ce que** la structure de boîtier est configurée de sorte que la structure de boîtier présente au moins sur des portions une paroi de boîtier déformable élastiquement, le long de laquelle au moins sur des portions au moins une conduite creuse reliée à la paroi de boîtier s'étend, et
**en ce que** la conduite creuse est reliée de manière étanche aux fluides avec une entrée et une sortie, par l'intermédiaire desquelles un milieu s'écoule à travers la conduite creuse.

7. Procédé selon la revendication 6,
**caractérisé en ce que** l'entrée et la sortie sont intégrés dans une plate-forme de construction sur laquelle la structure de boîtier est construit par couches et
**en ce que** le milieu est sélectionné de telle sorte que la paroi de boîtier déformable subisse pendant la suite du processus de compression une extension et/ou une compression après la fin du processus de construction.

8. Procédé de fabrication d'une structure de boîtier entourant au moins partiellement au moins un composant, dans lequel la structure de boîtier est fabriquée dans le cadre d'un processus de construction **caractérisé par** une découpe par couches répétées et/ou une solidification du matériau, qui avant la fabrication de la structure de boîtier est interrompue au moins une fois, et pendant l'interruption au moins un composant est assemblée sur ou dans la structure de boîtier partiellement fabriquée, qui n'est pas fabriqué avec le processus de fabrication et est sélectionné comme au moins un élément d'actionneur et/ou de capteur constitué partiellement d'un matériau convertisseur, et à la suite de l'interruption le processus de construction est poursuivi, jusqu'à ce que le logement, qui comprend au moins partiellement au moins un composant, soit considéré comme fini,
**caractérisé en ce que** la structure de boîtier est configurée de sorte que la structure de boîtier présente au moins par portions une paroi de boîtier déformable élastiquement,
à la suite d'une interruption une contrainte mécanique est exercée sur la structure de boîtier de telle sorte que la paroi de boîtier déformable élastiquement soit étirée, et **en ce que** après la finition de la structure de boîtier la contrainte mécanique soit arrêtée et l'extension de la paroi de boîtier déformable élastiquement soit réduite au moins partiellement par une force de rappel élastique agissant de manière inhérente au matériau, de sorte qu'une précontrainte mécanique agisse à partir des côtés de la structure de boîtier sur l'élément d'actionneur et/de capteur encastré, de sorte que la précontrainte mécanique s'exerce sous la forme d'une force de pressage, (Pk) agissant exclusivement des deux cotés en sens contraire, à partir des côtés de la structure de boîtier sur l'élément d'actionneur et/ou de capteur encastré.

9. Procédé selon la revendication 8,
**caractérisé en ce que** la contrainte mécanique est produite par une force externe agissant sur la structure de boîtier, qui s'exerce à l'aide d'une force de pression agissant latéralement sur la paroi de boîtier déformable élastiquement et/ou au moyen d'une force de traction agissant sur la structure de boîtier.

10. Procédé de fabrication d'une structure de boîtier entourant au moins partiellement au moins un composant, dans lequel la structure de boîtier est fabriquée dans le cadre d'un processus de construction **caractérisé par** une découpe par couches répétée et/ou une solidification du matériau, qui avant la fabrication de la structure de boîtier est interrompue au moins une fois, et pendant l'interruption au moins un composant est assemblé sur ou dans la structure de boîtier partiellement fabriquée, qui n'est pas fabriqué avec le processus de fabrication et est sélectionné comme au moins un élément d'actionneur et/ou de capteur constitué partiellement d'un matériau convertisseur, et à la suite de l'interruption le processus de construction est poursuivi, jusqu'à ce que le logement, qui comprend au moins partiellement au moins un composant, soit considéré comme fini,
**caractérisé en ce que** comme le composant à assembler au moins sur ou dans la structure de boîtier, un élément d'actionneur et/ou de capteur constitué au moins partiellement d'un matériau convertisseur piézo-électrique est sélectionné,
le matériau convertisseur piézo-électrique est chauffé avant l'implémentation dans la structure de boîtier partiellement finie, de sorte que le matériau piézo-électrique ne présente aucune polarisation rémanente notable,
l'élément d'actionneur et/ou de capteur constitué au moins partiellement du matériau convertisseur piézo-électrique est exposé après la finition du processus de construction à un champ électrique, qui entraîne la polarisation du matériau convertisseur piézo-électrique et sa dilatation, qui provoque une précontrainte mécanique à partir des côtés de la structure de boîtier sur l'élément d'actionneur et/ou de capteur encastré, de sorte que la précontrainte mécanique s'exerce sous la forme d'une force de pressage, (Pk) agissant exclusivement des deux cotés en sens contraire, à partir des côtés de la structure de boîtier sur l'élément d'actionneur et/ou de capteur encastré.

11. Procédé de fabrication d'une structure de boîtier entourant au moins partiellement au moins un composant, dans lequel la structure de boîtier est fabriquée dans le cadre d'un processus de construction **caractérisé par** une découpe par couches répétée et/ou une solidification du matériau, qui avant la fabrication de la structure de boîtier est interrompue au moins une fois, et pendant l'interruption au moins un composant est assemblé sur ou dans la structure de boîtier partiellement fabriquée, qui n'est pas fabriqué avec le processus de fabrication et est sélectionné comme au moins un élément d'actionneur et/ou de capteur constitué partiellement d'un matériau convertisseur, et à la suite de l'interruption le processus de construction est poursuivi, jusqu'à ce que le logement, qui comprend au moins partiellement au moins un composant, soit considéré comme fini,
**caractérisé en ce que** l'élément d'actionneur et/ou de capteur après l'implémentation dans la structure de boîtier partiellement finie est exposé à une contrainte mécanique, par l'intermédiaire de laquelle un élément d'actionneur et/ou de capteur subit un raccourcissement de longueur, et **en ce que** l'élément d'actionneur et/ou de capteur est englobé au moins partiellement par la structure de boîtier dans cet état de longueur raccourci et subit de cette manière une précontrainte mécanique à partir des côtés de la structure de boîtier, de sorte que la précontrainte mécanique s'exerce sous la forme d'une force de pressage, (Pk) agissant exclusivement des deux cotés en sens contraire, à partir des côtés de la structure de boîtier sur l'élément d'actionneur et/ou de capteur encastré.

12. Procédé selon une des revendications 1 à 11,
**caractérisé en ce que** avant ou après l'interruption du processus de construction et avant la finition de la structure de boîtier au moins une interruption supplémentaire du processus de construction est entreprise, pendant laquelle au moins un composant supplémentaire est assemblé sur ou dans la structure de boîtier partiellement fabriqué et/ou une manipulation sous la forme d'un usinage de surface mécanique, thermique, chimique et/ou physique sur la structure de boîtier partiellement fabriquée est entreprise sur la structure de boîtier partiellement fabriquée, qui ne peut pas être effectué dans le cadre du processus de construction et qui est poursuivi à la suite du processus de construction.

13. Structure de boîtier, qui enveloppe au moins un composant au moins partiellement, fabriquée avec un procédé selon une des revendications 1 à 12,
**caractérisé en ce que** au moins un composant à assembler sur ou dans la structure de boîtier est un élément d'actionneur et/ou de capteur constitué au moins partiellement d'un matériau convertisseur,
**en ce que** la structure de boîtier comprend au moins un composant monolithique
**en ce que** au moins un composant est assemblé avec la structure de boîtier par complémentarité de forme ou de matériau ou au moyen d'un promoteur d'adhérence adhésif.

14. Structure de boîtier selon la revendication 13,
**caractérisé en ce que** la structure de boîtier présente au moins une paroi de boîtier pouvant être fléchie, sur la paroi intérieure de boîtier de laquelle au moins un composant est assemblé et **en ce que** la structure de boîtier présente un contre palier, sur lequel s'appuie un moyen de serrage, qui peut être amené en liaison opérationnelle d'un côté avec la paroi de boîtier pouvant être fléchie.

15. Structure de boîtier selon une des revendications 13 à 14,
**caractérisée en ce que** au moins un composant supplémentaire est prévu, qui est fabriqué à partir d'un matériau qui est plus dur que le matériau constituant la structure de boîtier, et
le composant supplémentaire présente une portion dépassant en saillie à l'intérieur du boîtier, qui est en contact avec au moins un composant, ainsi qu'une portion dépassant en saillie extérieure de la structure de boîtier, qui présente une structure de fixation.

16. Structure de boîtier selon la revendication 13,
**caractérisée en ce que** la structure de boîtier présente au moins dans des zones partielles une paroi de boîtier déformable élastiquement, qui peut être fléchie biaxialement le long d'un axe spatial, **en ce que** l'élément d'actionneur et/ou de capteur présente une direction d'action d'actionneur et/ou de capteur, qui est orientée parallèlement à l'axe spatial, le long de laquelle l'élément d'actionneur et/ou de capteur subit une précontrainte mécanique à partir des côtés de structure de boîtier.
